Europäisches Patentamt

European Patent Office

Office européen des brevets

(11) Publication number: **0 072 144**
**B1**

# EUROPEAN PATENT SPECIFICATION

(45) Date of publication of patent specification: **19.10.88**

(51) Int. Cl.⁴: **H 03 M 1/18,** G 01 G 23/37

(21) Application number: **82303972.2**

(22) Date of filing: **27.07.82**

(54) **A-D converter for use in an electronic balance.**

(30) Priority: **31.07.81 JP 121294/81**

(43) Date of publication of application:
**16.02.83 Bulletin 83/07**

(45) Publication of the grant of the patent:
**19.10.88 Bulletin 88/42**

(84) Designated Contracting States:
**CH DE FR GB LI**

(56) References cited:
**FR-A-1 481 960**
**FR-A-2 378 401**
**US-A-3 327 229**
**US-A-3 516 085**
**US-A-3 794 815**
**US-A-3 981 005**
**US-A-4 251 802**

(73) Proprietor: **SHIMADZU CORPORATION**
**378, Ichinofunairi-cho Kawaramachi-dori Nijo**
**Sagaru**
**Nakagyo-ku Kyoto 604 (JP)**

(72) Inventor: **Komoto, Akira**
**3-10 Fujio Okumachi**
**Otsu-shi Shiga 520 (JP)**

(74) Representative: **Smith, Philip Antony et al**
**REDDIE & GROSE 16 Theobalds Road**
**London WC1X 8PL (GB)**

Courier Press, Leamington Spa, England.

## Description

The present invention relates to an A-D converter for use in an electronic balance.

A conventional high precision electronic balance takes a fairly long time to complete one measurement of weight, because of a slow response of the high-resolving A-D converter which is necessarily used in an electronic balance. In general, the response time of an A-D converter becomes the longer, the higher is its resolving power and the larger its converting capacity. Such being the case, it takes a very long time, especially when it is necessary for the balance to average a number of sampled weight values due to a noisy condition of weighing an object to be measured. Certainly there is known a high-resolving and high-speed A-D converter in which a D-A converter of a weighted-resistance type is incorporated. However, such an A-D converter has a disadvantage that the D-A converter incorporated therein, which requires many high-precision resistors, is temperature-sensitive, and therefore, liable to be unstable unless provided with a special temperature controlling means. Fine adjustment and preparation of the precision resistors are also troublesome.

The above inconveniencies accompanying an A-D converter for use in an electronic balance can be overcome to some extent with an A-D conversion system disclosed in U.S.—A—3,516,085. The system is devised so as to be capable of processing even a large (analog) signal with a precision but small capacity A-D converter. In principle the system consists of the A-D converter, an analog subtractor and a digital adder, and is constituted so that an analog signal to be processed may be inputted to the A-D converter through the signal subtractor. Each time an input to the A-D converter exceeds the saturation level of the converter in the course of increase in an input signal to the system, a constant unit value equal to the saturation level of the A-D converter is successively subtracted from the input signal to prevent the A-D converter from saturation. According to the number of subtraction operations a corresponding multiple of the subtracted unit value is added to the output of the A-D converter to make the system output a digitalized signal corresponding to, namely, equal to the analog input to the system.

However, the above A-D conversion system is still accompanied by a disadvantage that, if the variation speed of the input to the system is higher than the signal processing speed of the A—D converter employed, the output signal of the system does not respond to the input signal variations. Therefore, in case a rapid change in load is given, an electronic balance employing such an A-D conversion system can not provide any information on the applied load until the balance comes to show a final weight value of the load after the movement of the load receiving pan of the balance has settled down, namely, the input to the A-D conversion system has been fixed to a constant value. In the case where a predetermined weight of small items, liquid materials, powder materials or the like is to be weighed out, it is very inconvenient for an operator of the balance that the process in which the weight on the weighing tray is being offset by the balance is not shown even approximately, to the operator.

In accordance with the present invention there is provided an A-D converter for use in an electronic balance, comprising an analog signal subtractor for subtracting an analog subtraction signal from an analog signal externally inputted thereto to be digitalized by said A-D converter, an A-D converting unit for digitalizing an analog signal transferred thereto from said analog signal subtractor, first means for outputting a positive-overflow signal when the output of said A-D converting unit reaches a positive saturation level, second means for outputting a negative-overflow signal when the output of said A-D converting unit reaches a negative saturation level, third means for generating a digital subtraction signal according to said positive-overflow and said negative-overflow signals, a D-A converting unit for converting said digital subtraction signal to an analog signal to provide said analog subtraction signal, and a digital-signal adding means for adding said digital subtraction signal to the output of said A-D converting unit to give final digitalized signal equal to said analog signal externally inputted to said analog signal subtractor, being characterised in that said D-A converting unit is of a pulse-modulating type, and that the output of said analog subtractor is transferred to said A-D converting unit through a signal reducing means devised so as to reduce the output of said analog subtractor to 1/N of its value in accordance with said positive-overflow and said negative-overflow signals and to cease the signal reduction operation in accordance with an instruction signal from a signal stabilization detecting means for detecting the stabilization of the output of said A-D converting unit.

Brief description of the drawings

Fig. 1 is a block diagram showing an embodiment of the present invention:

Fig. 2 shows a graphic illustration of the output (or input) signal of the A-D converting unit 1a appearing in Fig. 1: and

Fig. 3 is a flow chart of the program stored in the ROM 10 incorporated in the above embodiment.

Detailed description of the invention

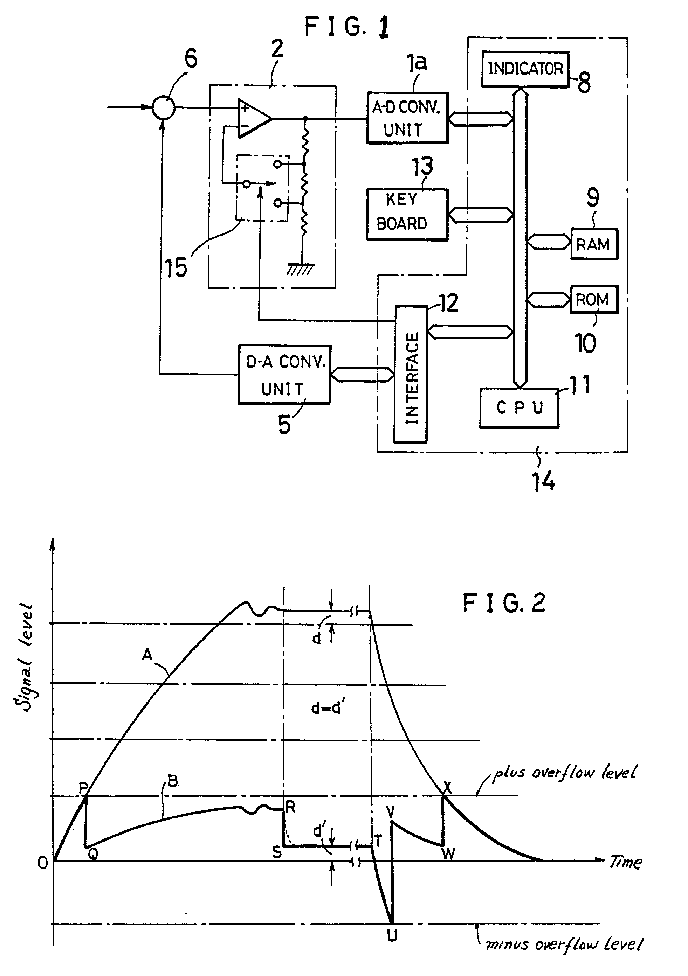

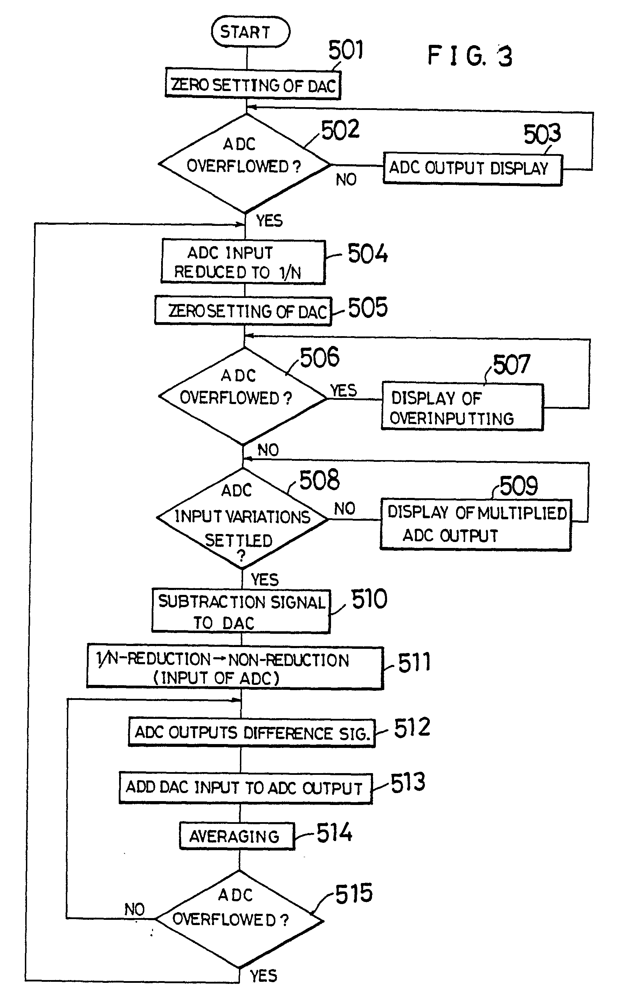

In the following, an embodiment of the present invention is described with reference to Figs. 1, 2 and 3. In Fig. 1 which shows a block diagram of the embodiment, there is provided a signal reducer 2 between an analog subtractor 6 and an A-D converting unit 1a. The signal reducer 2 can reduce the output signal of the A-D converting unit 1a to 1/N, being provided with a selection switch 15 by which either a 1/N-reduced or non-reduced signal is selectively outputted. The A-D converting unit 1a and the input of a pulse-width modulating D-A converting unit 5 are connected with a microcomputer 14 which comprises a CPU 11, ROM 10, RAM 9, interface 12 and indicator 8. Said selection switch also is operated by the signal from the microcomputer. In describing the function of this embodiment Fig. 2 is also referred to. In Fig. 2 a curve A means the signal to be measured, and a curve B shows the input (or output) of the A-D converting unit 1a. Initially the input and output of the D-A converting unit 5 are set to zero, and said selection switch 15 of the signal reducer 2 is set so that the signal reducer 2 may output a non-reduced signal. Therefore, the signal to be measured being inputted, the A-D converting unit 1a outputs a digitalized signal along the curve A in Fig. 2 until the output rises up to Point P which corresponds to the overflow level of the A-D converting unit 1a. The output of the A-D converting unit 1a reaching the overflow level, the signal reducer 2 reduces the input signal of the A-D converting unit 1a to 1/N with selection switch 15 operated by the signal from the microcomputer 14. The part between Q and R on the curve B corresponds to the 1/N-reduced input and, therefore, the output of the A-D converting unit 1a. During this period the indicator 8 of the microcomputer 14 displays an approximated value of the measured signal. When the output signal variation of the A-D converting unit 1a is settled down (Point R), the microcomputer 14 outputs to the D-A converting unit 5 a signal which corresponds to an integral multiple of the overflow signal of the A-D converting unit 1a, the multiplication factor being dependent on the value N. On receiving the signal the D-A converting unit 5 outputs an analog signal to be subtracted from the input to be measured. At the same time the output of the signal reducer 2 is changed to the non-reduced signal with the selection switch 15 operated also by the signal from the microcomputer 14. The part between S and T on the curve B shows that the A—D converting unit 1a outputs the difference signal. The microcomputer 14 adds the multiplied overflow signal of the A-D converting unit 1a to this difference signal, and display the sum of the indicator 8 as a total measured signal. The part between T and X on the curve B corresponds to the process in which the total input is decreasing to zero. In the process the input of the A-D converting unit 1a is reduced again to 1/N. The correspondence between each part or point on the curve B and each step in the flow chart shown in Fig. 3 is as follows: Step 502 corresponds to the part between O (the origin of the graph) and P; Step 504 to Q; Step 508 to R; Steps 510 and 511 to the part between R and S; and Step 512 to the part between S and T.

For the A-D converting unit 1a in the embodiment any of the commercially available A-D converting circuits such as 8052A/7103A, ICL7104 of Intersil and LD1200/LD121A of Silconix may well be employed. The details of the pulse-width modulating D-A converting unit which seems not available commercially, are disclosed, for instance, in a literature written by Yojiro Yokoi and published from Rajio (Radio) Gijutsusha in Japan under the title of "Linear IC Jitsuyo Kairo Manual". The D-A converting unit of pulse-width modulating type shows a high precision performance in spite of being easily assembled, though the response time is somewhat long. The long response time is not unfavourable in the present case, because the D-A converting unit is used for generating the subtraction signal which, in case of an electronic balance, does not vary so frequently. The high precision performance is important essentially.

Though the circuit to supply clock signals to the A-D and the D-A converting units (1a, 5), since it is a matter of common knowledge, is not mentioned in the above description, both the A-D converting unit 1a and the D-A converting unit 5 are preferably driven synchronously with each other by a common clock signal (whose generator is not shown in Fig. 1). Further, the A-D converting unit 1a may be of a voltage-frequency conversion type, of a double-integral type or of a successive-approximation type.

## Claims

1. An A-D converter for use in an electronic balance, comprising an analog signal subtractor (6) for subtracting an analog subtraction signal from an analog signal externally inputted thereto to be digitalized by said A-D converter, an A-D converting unit (1a) for digitalizing an analog signal transferred thereto from said analog signal subtractor (6), first means (14) for outputting a positive-overflow signal when the output of said A-D converting unit (1a) reaches a positive saturation level, second means (14) for outputting a negative-overflow signal when the output of said A-D converting unit (1a) reaches a negative saturation level, third means (14) for generating a digital subtraction signal according to said positive-overflow and said negative-overflow signals, a D-A converting unit (5) for converting said digital subtraction signal to an analog signal to provide said analog subtraction signal, and a digital-signal adding means (14) for adding said digital subtraction signal to the output of said A-D converting unit (1a) to give a final digitalized signal equal to said analog signal externally inputted to said analog signal subtractor (6), being characterised in that said D-A converting unit (5) is of a pulse-modulating type, and that the output of said analog subtractor (6) is transferred to said A-D converting unit (1a) through a signal reducing means (2) devised so as to reduce the output of said analog subtractor (6) to 1/N of its value in accordance with said positive-overflow and said negative-overflow signals and to cease the signal reduction operation in accordance with an instruction signal from a signal stablization detecting means (14) for detecting the stabilization of the output of said A-D converting unit (1a).

2. An A-D converter defined in claim 1, wherein said signal reducing means (2) consists of an amplifier and a switching means (15) for switching over the gain of said amplifier between unity and 1/N in accordance with said positive-overflow and said negative-overflow signals.

3. An A-D converter defined in claim 1 or 2, wherein both said pulse-modulating type D-A converting unit (5) and said A-D converting unit (1a) are driven synchronously with each other by a common clock.

4. An A-D converter defined in claim 1, 2 or 3, wherein said A-D converting unit (1a) is of a voltage-frequency conversion type.

5. An A-D converter defined in claim 1, 2 or 3, wherein said A-D converting unit (1a) is of a double-integral type.

6. An A-D converter defined in claim 1, 2 or 3, wherein said A-D converting unit (1a) is of a successive-approximation type.

## Patentansprüche

1. Analog-Digital-Wandler zur Verwendung in einer elektronischen Waage, zu dem ein Analogsignal-Substrahierglied (6) zum Subtrahieren eines analogen Subtraktionssignals von einem von außen eingegebenen, durch den genannten Analog-Digital-Wandler zu digitalisierenden analogen Signal gehört, eine Analog-Digital-Wandlereinheit (1a) zum Digitalisieren eines ihr vom dem genannten Analogsignal-Substrahierglied (6) aus zugeführten analogen Signals, eine erste Einrichtung (14) zum Ausgeben eines Positiv-Überlaufsignals, wenn der Ausgang der genannten Analog-Digital-Wandlereinheit (1a) einen positiven Sättigungspegel erreicht, eine zweite Einrichtung (14) zum Ausgeben eines Negativ-Überlaufsignals, wenn der Ausgang der genannten Analog-Digital-Wandlereinheit (1a) einen negativen Sättigungspegel erreicht, eine dritte Einrichtung (14) zum Erzeugen eines digitalen Substraktionssignals entsprechend den genannten Positiv-Überlauf- und Negativ-Überlaufsignalen, eine Digital-Analog-Wandlereinheit (5) zum Umwandeln des genannten digitalen Subtraktionssignals in ein analoges Signal, um das genannte analoge Substraktionssignal zu erzeugen, und eine Digitalsignal-Addiereinrichtung (14) zum Addieren des genannten digitalen Subtraktionssignals zum Ausgang der genannten Analog-Digital-Wandlereinheit (1a), um ein endgültiges digitalisiertes Signal zu erzeugen, das dem dem genannten Analogsignal-Substrahierglied (6) von außen eingegebenen analogen Signal gleicht, dadurch gekennzeichnet, daß die genannte Digital-Analog-Wandlereinheit (5) vom impulsmodulierenden Typ ist und daß der Ausgang des genannten Analog-Subtrahiergliedes (6) an die genannte Analog-Digital-Wandlereinheit (1a) über eine Signalreduzierungseinrichtung (2) übertragen wird, die so ausgebildet ist, daß sie den Ausgang des genannten Analog-Subtrahiergliedes (6) auf 1/N seines Wertes gemäß den genannten Positiv-Übelauf- und Negativ-Überlaufsignalen reduziert und die Signalreduzierungsoperation gemäß einem Befehlssignal von einer Signalstabilisierungs-Detektoreinrichtung (14) zum Erfassen der Stabilisierung des Ausgangs der genannten Analog-Digital-Wandlereinheit (1a) beendet.

2. Analog-Digital-Wandler nach Anspruch 1, dadurch gekennzeichnet, daß die genannte Signalreduzierungeinrichtung (2) aus einem Verstärker und einer Schalteinrichtung (15) besteht, die dazu dient, den Verstärkungsfaktor des genannten Verstärkers gemäß den genannten Positiv-Überlauf- und Negative-Überlaufsignalen zwischen Eins und 1/N umzuschalten.

3. Analog-Digital-Wandler nach Anspruch 1 oder 2, dadurch gekennzeichnet, daß beide, die genannte Digital-Analog-Wandlereinheit (5) vom impulsmodulierenden Typ und die genannte Analog-Digital-Wandlereinheit (1a) synchron miteinander durch einen gemeinsamen Taktgeber angetrieben werden.

4. Analog-Digital-Wandler nach Anspruch 1, 2 oder 3, dadurch gekennzeichnet, daß die genannte Analog-Digital-Wandlereinheit (1a) eine solche vom Spannungsfrequenzwandlertyp ist.

5. Analog-Digital-Wandler nach Anspruch 1, 2 oder 3, dadurch gekennzeichnet, daß die genannte Analog-Digital-Wandlereinheit (1a) eine solche vom Doppelintegraltyp ist.

6. Analog-Digital-Wandler nach Anspruch 1, 2 oder 3, dadurch gekennzeichnet, daß die genannte Analog-Digitalwandlereinheit (1a) vom Stufenumsetzungstyp ist.

## Revendications

1. Un convertisseur A-N destiné à être utilisé dans une balance électronique, comprenant un soustracteur de signal analogique (6) destiné à soustraire un signal de soustraction analogique d'un signal analogique qui lui est appliqué de l'extérieur et qui doit être numérisé par ledit convetisseur A-N, une unité (1a) de conversion A-N destinée à numériser un signal analogique qui lui est appliqué par ledit soustracteur (6) de signal analogique, un premier dispositif (14) pour fournir un signal de débordement positif lorsque la sortie de l'unité (1a) de conversion A-N atteint un niveau de saturation positif, un second dispositif (14) destiné à fournir un signal de débordement négatif lorsque la sortie de l'unité (1a) de conversion A-N atteint un niveau de saturation négatif, un troisième dispositif (14) destiné à engendrer un signal de soustraction numérique en fonction desdits signaux de débordement positif et de débordement négatif, une unité (5) de conversion N-A pour convertir ledit signal de soustraction numérique en un signal analogique afin de fournir ledit signal de soustraction analogique, et un dispositif (14) d'addition de signal numérique destiné à additionner ledit signal de soustraction numérique et la sortie de ladite unité (1a) de conversion A-N pour produire un signal final numérisé égal audit signal analogique appliqué de l'extérieur audit soustracteur (6) de signal analogique, ce convertisseur étant caractérisé en ce que ladite unité (5) de conversion N-A est du type à modulation par impulsions, et en ce que la sortie dudit soustracteur analogique (6) est transférée à ladite unité (1a) de conversion A-N, par l'intermédiaire d'un dispositif de réduction de signal (2) conçu de manière à réquire la sortie dudit soustracteur analogique (6) à 1/N de sa valeur en fonction desdits signaux de débordement positif et de débordement négatif, et à cesser l'opération de réduction de signal en fonction d'un signal d'instruction provenant d'un dispositif (14) de détection de stabilisation de signal destiné à détecter la stablilisation de la sortie de ladite unité (1a) de conversion A-N.

2. Un convertisseur A-N tel que défini dans la revendication 1, dans lequel ledit dispositif (2) de réduction de signal comprend un amplificateur et un dispositif de commutation (15) destiné à commuter le gain dudit amplificateur entre l'unité et 1/N en fonction desdits signaux de débordement positif et de débordement négatif.

3. Un convertisseur A-N tel que défini dans la revendication 1 ou 2, dans lequel ladite unité (5) de conversion N-A du type à modulation par impulsions et ladite unité (1a) de conversion A-N sont commandées ensemble de façon synchrone par une horloge commune.

4. Un convertisseur A-N tel que défini dans la revendication 1, 2 ou 3, dans lequel ladite unité (1a) de conversion A-N est du type à conversion fréquence-tension.

5. Un convertisseur A-N tel que défini dans la revendication 1, 2 ou 3, dans lequel ladite unité (1a) de conversion A-N est du type à double intègration.

6. Un convertisseur A-N tel que défini dans la revendication 1, 2 ou 3, dans lequel ladite unité (1a) de conversion A-N est du type à approximations successives.

**0 072 144**

FIG. 1

FIG. 2

# 0 072 144

F I G. 3

START — 501

ZERO SETTING OF DAC

502 — ADC OVERFLOWED ? — NO → ADC OUTPUT DISPLAY — 503

YES

ADC INPUT REDUCED TO 1/N — 504

ZERO SETTING OF DAC — 505

506 — ADC OVERFLOWED ? — YES → DISPLAY OF OVERINPUTTING — 507

NO

508 — ADC INPUT VARIATIONS SETTLED ? — NO → DISPLAY OF MULTIPLIED ADC OUTPUT — 509

YES

SUBTRACTION SIGNAL TO DAC — 510

1/N-REDUCTION → NON-REDUCTION (INPUT OF ADC) — 511

ADC OUTPUTS DIFFERENCE SIG. — 512

ADD DAC INPUT TO ADC OUTPUT — 513

AVERAGING — 514

515 — ADC OVERFLOWED ? — NO

YES